# EUROPEAN PATENT APPLICATION

(11) **EP 4 465 357 A1**
(43) Date of publication of application: **20.11.2024**
(21) Application number: 23174091.1
(22) Date of filing: 17.05.2023
(51) Int. Cl.: H01L 27/02, H01L 29/423, G06N 10/40

(54) **A SEMICONDUCTOR PROCESSING DEVICE, A METHOD OF MANUFACTURING THEREOF, AND A QUANTUM COMPUTING UNIT**

(71) Applicant: Nederlandse Organisatie voor toegepast-natuurwetenschappelijk Onderzoek TNO, 2595 DA 's-Gravenhage (NL)
(72) Inventor: SAMKHARADZE, Nodar, 2595 DA 's-Gravenhage (NL); AMITONOV, Sergey Vladimirovich, 2595 DA 's-Gravenhage (NL); MICHALAK, David Jason, 2595 DA 's-Gravenhage (NL)
(74) Representative: V.O.

(57) **Abstract**

A cryogenic semiconductor processing device designed to operate under low-temperature conditions. The device includes a semiconductor substrate, at least one gate electrode layer, and a dielectric layer partially situated between the gate electrode layer and the substrate. The dielectric layer is not present in at least one subregion, creating a direct connection between the gate electrode layer and the substrate. The invention also relates to a method of manufacturing the cryogenic semiconductor processing device.

## Description

### FIELD OF THE INVENTION

The invention relates to a cryogenic semiconductor processing device configured to operate under cryogenic conditions, the cryogenic semiconductor device comprising a semiconductor substrate, at least one gate electrode layer, and a dielectric layer partially arranged between the gate electrode layer and the semiconductor substrate. Furthermore, the invention also relates to a method of manufacturing a semiconductor processing device. Additionally, the invention relates to an electronic device comprising a cryogenic semiconductor processing device. Also, the invention relates to a quantum computing unit comprising a cryogenic semiconductor processing device.

### BACKGROUND TO THE INVENTION

Electrostatic discharge (ESD) protection for cryogenic devices poses a significant challenge in the field of micro or nanoscale semiconductor devices. ESD occurs when a buildup of electrostatic charge momentarily flows through a device, causing harmful effects and often leading to the breakdown of the dielectric surrounding the electrodes. ESD events typically occur at the points where electrodes are closest to each other, which tend to coincide with the "active region" of the device, where e.g. transistors or quantum dots are formed. There is need for effective ESD protection strategies since conventional ESD protection measures can negatively impact device performance or require additional, potentially detrimental fabrication steps.

Previous approaches to ESD protection have employed on-chip transient voltage suppressors, typically diode-based, or shorting strips between electrodes that are removed after wire bonding. However, these methods can be detrimental to the performance of the device, as they can increase the parasitic capacitance of the electrodes and add complexity to the fabrication process. Furthermore, these approaches may not be suitable for cryogenic semiconductor devices, as they can compromise the intended functionality of the device or fail to provide adequate protection under cryogenic operating conditions.

Cryogenic devices are not yet widespread in the industry, and the development of ESD protection strategies that specifically cater to the unique requirements of cryogenic semiconductor devices remains an important issue.

The growing interest in quantum computing and other cryogenic applications has created a strong desire for a novel ESD protection method that addresses these challenges while maintaining the performance and reliability of cryogenic semiconductor devices. To be effective, such a method must take advantage of the unique temperature-dependent properties of semiconductors, protect the active region of the device, and avoid unnecessary fabrication steps or structures that could degrade device performance.

The development of an ESD protection strategy specifically tailored to cryogenic semiconductor devices would have significant implications for various industries and applications. Industries working for example on quantum dot-based quantum computing can benefit from an ESD protection solution that enables easier fabrication and improved performance of cryogenic devices. Additionally, there is a need for a solution that can be applied beyond quantum computing, encompassing any field that involves cryogenic operation of semiconductor devices.

### SUMMARY OF THE INVENTION

It is an object of the invention to provide for a method and a system that obviates at least one of the above mentioned drawbacks.

Additionally or alternatively, it is an object of the invention to provide for an improved cryogenic semiconductor processing device, and an improved method of manufacturing a semiconductor processing device.

Additionally or alternatively, it is an object of the invention to improve ESD protection for cryogenic semiconductor devices that operate under specific requirements of cryogenic applications.

Thereto, the invention provides for a cryogenic semiconductor processing device configured to operate under cryogenic conditions, the cryogenic semiconductor device comprising a semiconductor substrate, at least one gate electrode layer, and a dielectric layer partially arranged between the gate electrode layer and the semiconductor substrate, wherein the dielectric layer is absent in at least one first subregion between the gate electrode layer and the semiconductor substrate providing a direct connection therebetween.

The device of the invention achieves significant advantages by incorporating a novel ESD protection strategy specifically tailored for cryogenic semiconductor devices. The key device feature that contributes to this advantageous technical effect is the partial removal of the dielectric layer under the gate electrode layer, allowing direct contact with the substrate at room temperature. This design ensures a controlled discharge path for ESD events during critical stages such as fabrication and/or packaging when ESD events are most likely to occur, effectively protecting the active region of the device.

The active region of a semiconductor computing device is the specific area where the key electronic or quantum components, such as transistors or quantum dots, actively participate in charge transport and information processing, directly contributing to the device's intended functionality and performance. In contrast, the non-active region of a semiconductor computing device may be understood as the area that does not directly participate in or contribute to the primary electronic or quantum processes, such as charge transport and information processing, but instead provides e.g. support, isolation, and/or stability for the device's overall structure and operation.

As the device is cooled to cryogenic temperatures during functional operation of the device, the semiconductor substrate, for example intrinsic or compensation-doped semiconductor substrate, exhibits freeze-out, which results in the electrical insulation of the electrodes and enables the device to operate as intended without any interference from ESD protection measures. This temperature-dependent behavior is a unique and innovative aspect of the device that directly addresses the challenges associated with ESD protection in cryogenic semiconductor devices.

Optionally, the device is configured to prevent ESD at room temperature by short-circuiting the non-active regions through the semiconductor substrate.

Optionally, the at least one first subregion does not encompass one or more active regions of the gate electrode layer.

By removing of the dielectric layer only outside the active region or only (selectively) providing the dielectric layer in the active region, the device can effectively maintain the necessary insulation in areas where for example overlapping gate metals or regions require two-dimensional electron gas functionality, whilst mitigating risks associated to ESD. This selective approach ensures optimal device performance and minimizes any negative impact on the device's operation at cryogenic temperatures.

Compared to conventional ESD protection methods, the device of the invention simplifies fabrication and eliminates the need for additional structures that could potentially degrade device performance. This leads to improved reliability and overall performance of the device, which can be of significant importance for applications such as quantum computing/processing, where high precision and stable operation are critical.

The active region can contact a dielectric material such as aluminum oxide, or any other dielectric material. Such regions may be required, since at certain points/zones the gate layers overlap. In areas where gate layers no longer overlap, once the semiconductor undergoes freeze-out, they become insulated due to spatial separation. In some examples, a distinction is made between active region and non-active region, wherein the dielectric layer is absent in at least portions of the non-active region. In some examples, a dielectric layer covers a larger area and is subsequently removed from (at least some parts of) the non-active region, specifically in areas where the dielectric material is not desired such as to effectively reduce the risk of ESD during various stages.

Optionally, the non-active region does not include any areas/zones where gate metal layers overlap. Furthermore, there is no two-dimensional (2D) electron gas or 2D charge carrier gas present in the non-active region. Charge carriers in the semiconductor are crucial for the operation of the device, including source, drain, and quantum dot functions.

The relationship between a 2D electron gas and the active region of a semiconductor computing device lies in the fact that a 2D electron gas can be an integral part of the active region in certain types of devices. The 2D electron gas is a system where the motion of electrons is confined to two dimensions, leading to unique electronic properties and behaviors.

In some semiconductor computing devices, such as field-effect transistors (FETs), high electron mobility transistors (HEMTs), or quantum devices using quantum wells or quantum dots, the 2D electron gas forms within the active region. It contributes to the device's functionality by providing a conductive channel for electron transport, leading to high-speed performance and improved efficiency.

Thus, the 2D electron gas can be a crucial component within the active region of specific semiconductor computing devices, playing a vital role in their operation and the realization of their intended functions.

Optionally, the dielectric layer is only provided in at least one second subregion between the gate electrode layer and the semiconductor substrate, wherein the at least one second subregion envelops one or more active regions of the gate electrode layer.

The device of the invention provides a highly effective, temperature-dependent ESD protection strategy that specifically targets the unique challenges faced by cryogenic semiconductor devices. By partially removing the dielectric layer under the electrodes and leveraging the temperature-dependent properties of semiconductors, the device offers a tailored solution that ensures ESD protection during fabrication and packaging without compromising performance during cryogenic operation.

The active region may consist of areas with a multi-layered configuration, containing metallic gate layers that are separated by a dielectric material, such as aluminum oxide.

In some examples, the active region of the cryogenic semiconductor processing device is situated in the central portion of the device. This active region may be positioned at the center of the device's surface.

In the central region, certain structures require isolation from one another. However, in other areas of the device where the gate metal layers are not stacked, but rather spatially separated, the gate electrodes are placed directly on the semiconductor substrate without any oxide layer. In some examples, the substrate may include silicon or any other semiconductor material.

Optionally, the at least one second subregion delineates the one or more active regions of the gate electrode layer.

At room temperature, when the substrate is conductive, all gate metal layers are electrically connected through the substrate. This prevents charge accumulation on large metal sections and effectively protects against electrostatic discharge. Upon cooling the device for cryogenic operation, the substrate undergoes a "freeze-out" process, during which its conductive properties diminish, and the electrical connection between the electrodes is eliminated. Consequently, the device can function as intended while operating under cryogenic conditions.

Optionally, the dielectric layer is provided with varying thicknesses across different subregions between the gate electrode layer and the semiconductor substrate, wherein a reduced thickness dielectric layer is provided in a margin area surrounding the active region of the device.

Optionally, between 10% to 90% of a total area between the gate electrode layer and the semiconductor substrate is substantially unoccupied by the dielectric layer.

In this way, the invention provides for a robust and practical solution for ESD protection for semiconductor devices aimed at cryogenic operations, improving their reliability and operational lifespan.

Optionally, at least 40% of a total area between the gate electrode layer and the semiconductor substrate is substantially unoccupied by the dielectric layer, preferably at least 50%, more preferably at least 60%, even more preferably at least 70%.

A higher unoccupied region may result in increased ESD protection. Hence, by selectively providing the dielectric layer only at locations where it is needed, covering the active region of the device, the ESD protection can be significantly improved.

Optionally, the at least one second subregion covers portions of the gate electrode layer in which multiple gate metals are arranged on top of each other with at least partial overlap therebetween.

Optionally, the at least one second subregion covers portions of the gate electrode layer including accumulation gates.

Optionally, the at least one second subregion covers areas where during operation charge carriers are created in the semiconductor for providing the functionality of the device.

The device's active region, which is necessary for proper functionality, is located in the central part of the semiconductor processing device. This active region comprises a multi-layered structure with metallic gates separated by a dielectric material, such as aluminum oxide. These gates are necessary for creating charge carriers in the semiconductor substrate, which can be needed for the device's functionality. The dielectric layer may be provided only in or around the active region, where it is required for operation at low temperatures. In contrast, the non-active region of the device does not require a dielectric layer at low temperatures. The dielectric layer is selectively provided or partially removed from this region. The absence of the dielectric layer in the non-active region results in conductive paths at room temperature. However, when the device is cooled to cryogenic operating temperatures, the substrate freezes out, eliminating conductive paths between the gate electrodes and allowing the device to function as intended.

Optionally, the cryogenic device is configured to operate under thermal conditions that result in a freeze-out phenomenon for the semiconductor substrate.

The term "freeze-out" may be understood as the phenomenon observed in semiconductors when the temperature is lowered for cryogenic operation. As the temperature decreases, fewer electrons are available in the conduction band, resulting in the "freeze-out" effect. The device may be configured to operate at temperatures where freeze-out takes place. Such temperatures may be considered temperatures at which the cryogenic device operates.

Optionally, the semiconductor substrate is an intrinsic or compensation-doped substrate.

The cryogenic operation of the device can depend on the freeze-out temperature of the semiconductor material used in the substrate. This freeze-out temperature is material-dependent and marks the point at which the substrate becomes non-conductive. The invention is designed to operate at temperatures at which freeze-out occurs for intrinsic or compensated doped substrates.

Optionally, the semiconductor substrate is provided with intrinsic and compensation-doped regions for improved freeze-out characteristics.

Optionally, the dielectric layer comprises multiple dielectric materials with varying dielectric properties.

Optionally, the at least one first subregion and the at least one second subregion have distinct geometries to optimize the performance of the device.

Optionally, the device includes multiple stacked gate electrode layers.

According to an aspect, the invention provides for a method of manufacturing a semiconductor processing device, the method including providing a semiconductor substrate, at least one gate electrode layer and a dielectric layer arranged between the gate electrode layer and the semiconductor substrate, wherein the dielectric layer is omitted in at least one first subregion between the gate electrode layer and the semiconductor substrate providing a direct connection therebetween.

The method of the invention offers several key advantages for ESD protection in cryogenic semiconductor devices. By leveraging the temperature-dependent properties of semiconductors, this approach provides effective ESD protection during stages when ESD events may occur, such as for instance during packaging, fabrication, etc., advantageously without compromising device performance during cryogenic operation. By partially removing the dielectric under the electrodes and allowing contact with the substrate at room temperature, the method enables controlled ESD discharge without damaging the active region of the device. As the device is cooled to cryogenic temperatures, the intrinsic or compensation-doped semiconductor substrate freezes out, effectively insulating the electrodes and allowing for normal device operation.

In contrast to traditional ESD protection methods, this approach simplifies the fabrication process by avoiding the need for additional structures that can degrade device performance, such as transient voltage suppressors or shorting strips. This leads to a more efficient and streamlined fabrication process, ultimately resulting in improved device performance and reliability.

In some examples, the method can be used for manufacturing a device for quantum dot-based quantum computing. However, the method can also be used for manufacturing device for various other applications across various industries and domains where cryogenic operation of the semiconductor devices is employed. The development of this novel ESD protection strategy represents a significant advancement in the field, offering a tailored solution to the unique challenges faced by cryogenic semiconductor devices and paving the way for broader adoption of these devices in diverse applications.

Optionally, the method includes: depositing a dielectric material onto the semiconductor substrate, wherein the dielectric material is configured to substantially cover the semiconductor substrate, selectively remove the dielectric material from the semiconductor substrate while maintaining the dielectric material over one or more active regions of the gate electrode layer, resulting in a partially removed dielectric layer so that is only present enveloping the one or more active regions of the gate electrode layer.

There are several techniques available to partly or selectively remove a dielectric layer in semiconductor device fabrication. Some exemplary methods include:
Photolithography and Etching: This process involves coating the dielectric layer with a photosensitive material called photoresist. The photoresist is then selectively exposed to ultraviolet (UV) light through a photomask that defines the desired pattern. The exposed (or unexposed, depending on the type of photoresist) regions are then chemically developed, leaving a patterned photoresist layer on the dielectric. The dielectric layer is etched using either wet or dry etching methods, selectively removing the exposed dielectric material while leaving the protected areas intact. Finally, the remaining photoresist is stripped away.

Focused Ion Beam (FIB) Milling: This technique uses a focused beam of ions, typically gallium ions, to selectively remove material from the dielectric layer. The FIB milling process is highly precise and can be controlled with nanometer-scale accuracy, making it suitable for removing small portions of dielectric layers.

Laser Ablation: In this method, a high-energy laser beam is focused onto the dielectric layer, selectively removing the material through a process called ablation. The laser's energy can be adjusted to control the rate of material removal, and the laser can be directed with high precision to selectively remove specific areas of the dielectric layer.

Mechanical or Chemical-Mechanical Polishing (CMP): This technique uses a combination of mechanical polishing and chemical etching to selectively remove material from the dielectric layer. The process involves polishing the surface using an abrasive slurry and a polishing pad. The rate of material removal can be controlled by adjusting the pressure, slurry composition, and polishing time.

The choice of technique may depend on the specific requirements of the semiconductor device and its fabrication process. For example, the dielectric layer may be selectively removed through a lift-off process for precise control of the dielectric layer coverage.

Optionally, the method includes: selectively depositing a dielectric material onto the semiconductor substrate through a patterned deposition process, wherein the dielectric material is configured to be selectively applied over one or more active regions of the gate electrode layer.

According to an aspect, the invention provides for an electronic device comprising a cryogenic semiconductor processing device according to the disclosure.

The electronic device may comprise a thermal management system configured to maintain a predetermined temperature gradient across the semiconductor substrate during operation. In some examples, the electronic device is provided with an (integrated) temperature sensor for monitoring and controlling cryogenic operating conditions.

According to an aspect, the invention provides for a quantum computing unit comprising a cryogenic semiconductor processing device according to the disclosure.

According to the invention, the dielectric layer (e.g. AlOx layer) may be selectively/partially removed (and/or selectively provided such that some regions the layer is absent). The selective/partial removal may for instance be performed by means of selectively etching the dielectric layer beneath the majority of the gate electrode layer. The dielectric layer is retained only within the device's active area, where overlapping of the metal layers occurs. In the regions beyond the active area, leakage prevention is assured by the freeze-out phenomenon of the semiconductor at cryogenic temperatures. This advantageous technique reduces unnecessary insulation, optimizes device performance, and simplifies fabrication processes while ensuring the integrity and effectiveness of the device's operation.

According to an aspect, the invention provides for a method of operating a cryogenic semiconductor processing device according to the disclosure, the method comprising: cooling the device to cryogenic operating temperatures; causing the semiconductor substrate to freeze out, eliminating conductive paths between the gate electrode layer and the semiconductor substrate; and operating the device under cryogenic conditions to perform its intended functionality.

The present invention presents significant advantages in providing ESD protection for semiconductor devices intended for cryogenic applications. The innovative method is characterized by its simplicity, eliminating the need for extra processing steps that could potentially compromise the device's quality. This streamlined approach facilitates a more straightforward fabrication process for ESD-safe semiconductor devices, enhancing manufacturing efficiency. Additionally, the invention eliminates the need for superfluous structures on the device. Such unnecessary elements could otherwise negatively impact the device's performance by introducing additional complexity or potential points of failure. Thus, through the adoption of this invention, the integrity, performance, and reliability of semiconductor devices for cryogenic applications are substantially improved.

It will be appreciated that in the at least one first subregion between the gate electrode layer and the semiconductor substrate it is possible that a conductive layer (e.g. ferroelectric material) is provided. In this way, the gate electrode layer is connected to the semiconductor substrate via said conductive layer.

It will be appreciated that the semiconductor processing/computing device may be understood as a computing device or a computing component. The processing device may be configured to perform calculations, data processing and/or executing instructions in a variety of computing systems; Examples include integrated circuits, processors, quantum processors, etc.

It will be appreciated that in a semiconductor computing/processing device, the active region is the part that provides functionality and enables the processing to be performed. This region is typically composed of various semiconductor components like transistors, diodes, and resistors that work together to carry out the desired functions. The active region may also be referred to as the "active layer" or "active area" of the device.

It will be appreciated that the term "active region" of a semiconductor device is a fundamental concept in the design, fabrication, and operation of semiconductor devices. The active region of a semiconductor device can refer to the portion of the device where the primary electronic activities, such as charge transport, generation, and recombination, occur. This region is responsible for the device's intended functionality and performance. In a semiconductor device, the active region is the area where critical components, such as transistors, diodes, and resistors, interact and/or operate to enable the processing, storage, or transmission of information. The active region forms the basis for the device's core functionality.

The active region of a semiconductor device encompasses the zones where the primary electronic processes take place, enabling the execution of intended functions. It consists of various semiconductor elements that work together to carry out these processes and ensure the efficient operation of the device.

It will be appreciated that a non-active region in a semiconductor computing device may refer to the portion of the device that does not directly participate in the primary electronic or quantum activities, such as charge transport, generation, or recombination. These regions typically serve as support structures, providing mechanical stability, electrical isolation, or thermal management, and contribute indirectly to the overall performance and functionality of the device.

It will be appreciated that a dielectric layer in a semiconductor computing device may be understood as an insulating layer made of a material with low electrical conductivity and high dielectric strength. The primary function of a dielectric layer is to electrically isolate different regions or components of the device, preventing unwanted interactions or short-circuits between them. Dielectric layers are widely used in various semiconductor devices, such as integrated circuits and field-effect transistors (FETs), including metal-oxide-semiconductor FETs (MOSFETs), where they form the gate insulator. Some common materials used for dielectric layers include silicon dioxide (SiO2), silicon nitride (Si3N4), hafnium oxide (HfO2), and other high-k dielectric materials. The choice of dielectric material depends on factors such as the required electrical properties, thermal stability, compatibility with other materials in the device, and fabrication processes. In some examples, aluminum oxide (Al2O3 is used as a dielectric layer in semiconductor computing devices. Aluminum oxide is an insulating material with a high dielectric strength and a relatively high dielectric constant (around 9). It offers good thermal stability, chemical resistance, and compatibility with various semiconductor materials and fabrication processes.

It will be appreciated that a gate electrode layer may also be referred to as a "control layer" or "control electrode layer." This term refers to the layer that controls the flow of charge carriers in the transistor channel and, thus, the operation of the transistor. The gate electrode layer may also be referred to as an "electrostatic gate layer" or simply "gate layer" for a quantum processor with gate-defined quantum dots. The gate layer may create electrostatic potentials that define and manipulate the quantum dots and control the quantum states of the qubits. It also encompasses the various gate types, such as control gates, plunger gates, and barrier gates, that are used in different configurations and roles within the quantum processor.

It will be appreciated that any of the aspects, features and options described in view of the method apply equally to the system and the described electronic device and quantum computer. It will also be clear that any one or more of the above aspects, features and options can be combined.

### BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:
Fig. 1 shows a schematic diagram of prior art semiconductor device;
Fig. 2 shows a schematic diagram of a cross-sectional view of an embodiment of a cryogenic semiconductor processing device;
Fig. 3 shows a schematic diagram of a top view of an embodiment of a cryogenic semiconductor processing device;
Fig. 4 shows a schematic diagram of an embodiment of an active region; and
Fig. 5 shows a schematic diagram of a top view of an embodiment of a cryogenic semiconductor processing device.

### DETAILED DESCRIPTION

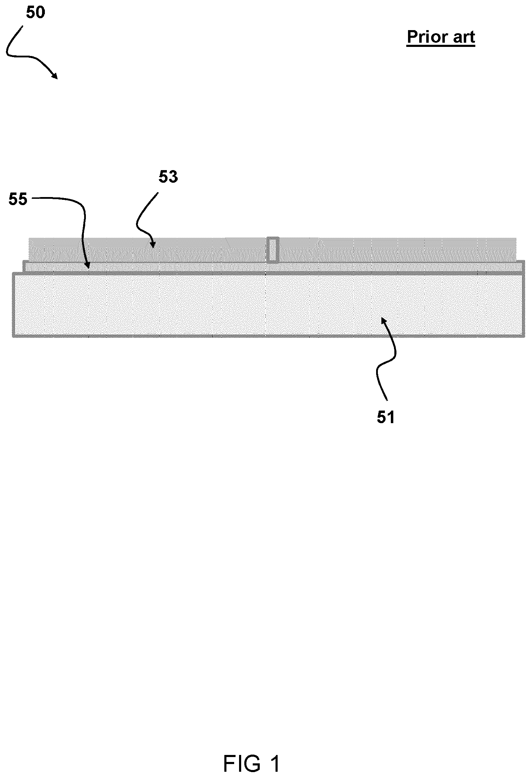

Fig. 1 shows a schematic diagram of prior art semiconductor device 50. The device 50 includes a semiconductor substrate 51, a gate electrode layer 53, and a dielectric layer 55 arranged between the gate electrode layer 53 and the semiconductor substrate 51. The dielectric layer substantially covers the area of the gate electrode layer 53. This coverage includes both the active and the non-active regions of the semiconductor device 50.

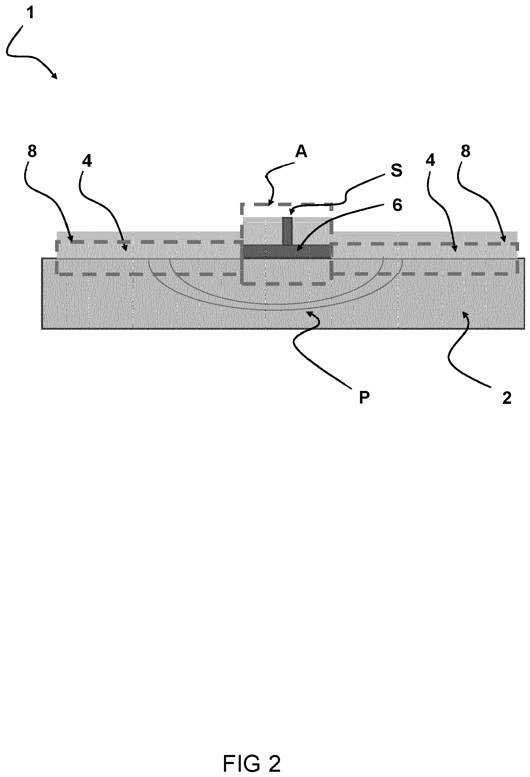

Fig. 2 shows a schematic diagram of a cross-sectional view of an embodiment of a cryogenic semiconductor processing device 1 according to the invention. The device 1 is configured to operate under cryogenic conditions. The device 1 has a semiconductor substrate 2, at least one gate electrode layer 4, and a dielectric layer 6 partially arranged between the gate electrode layer 4 and the semiconductor substrate 2. The dielectric layer 6 is absent in at least one first subregion 8 (indicated by dashed lines) between the gate electrode layer and the semiconductor substrate providing a direct connection therebetween. The dielectric layer 6 may for example be selectively provided/deposited and/or partially removed in the first subregion 8. In some examples, the first sub-region includes the non-active region of the device (cf. only area that covers the active region (e.g. with margin) is connected to the dielectric layer 6).

The semiconductor substrate 2 may be configured to freeze out at cryogenic operating temperatures. A conductive path P can be formed at non-cryogenic temperatures (e.g. room temperature, or temperatures employed during manufacturing, packaging, etc.). The conductive path P freezes out at cryogenic temperatures.

In the shown example, a dielectric layer 6 is provided between the gate electrode layer 4 and the semiconductor substrate 2 at the active region A of the device. The ESD susceptible region of the device is indicated by S. The gate electrode layer 4 may include electrodes. The semiconductor substrate may be intrinsic or compensated-doped substrate in some examples.

The device may function as a transistor, integrated circuit, or quantum processor, or the like.

In some examples, the device comprises an active region and a non-active region, the dielectric layer being present in the active region and absent in the non-active region.

The active region of a semiconductor computing device 1, including quantum processors with quantum dots or devices utilizing a 2D electron gas, refers to the portion where primary electronic and quantum activities occur. This region is responsible for the device's intended functionality, enabling both quantum and classical information processing while taking into account the unique properties and behaviors of 2D electron gas systems.

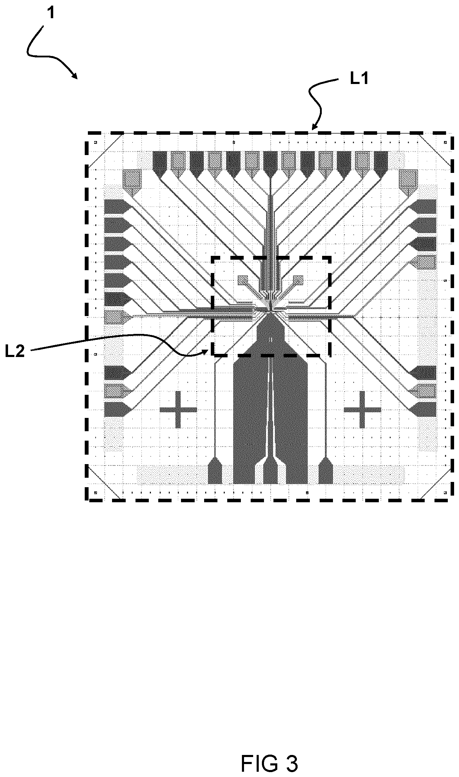

Fig. 3 shows a schematic diagram of a top view of an embodiment of a cryogenic semiconductor processing device 1. In this example, the semiconductor processing device 1 is a quantum processor. In this example, the device 1 comprises gate-defined quantum dots in the active region. The dielectric layer 6 is absent in at least one first subregion 8 between the gate electrode layer and the semiconductor substrate providing a direct connection therebetween. In this example, the subregion 8 is defined as the area between square L1 and square L2. Square L1 encompasses the active region of the device 1.

The dielectric layer 6 (not shown) can be partially removed or selectively provided. In some instances, the dielectric layer is first deposited over the entire surface and then partially removed to achieve the desired configuration.

In quantum processor computing devices, the active region contains components that directly contribute to the processing and manipulation of quantum information. Some examples of these components may include:
Qubits: The fundamental building blocks of quantum computing devices, qubits (quantum bits) are the quantum analog of classical bits, representing the smallest unit of quantum information. They can exist in superpositions of states, enabling quantum parallelism. Various physical systems can be used to implement qubits, such as trapped ions, superconducting circuits, or quantum dots. Quantum dots are nanoscale semiconductor structures that exhibit unique quantum properties, such as quantized energy levels and size-tunable bandgaps, due to their confinement of electrons in three dimensions. In the context of quantum computing, quantum dots can be used to implement qubits by exploiting the discrete energy levels and spin properties of confined electrons or holes. These quantum dot-based qubits can then be manipulated using external electric and magnetic fields or optical techniques to perform quantum operations and build quantum circuits. Thus, quantum dots play a direct role in the processing and manipulation of quantum information, making them part of the active region in quantum processor computing devices.

Quantum gates: Quantum operations that manipulate the states of qubits, analogous to classical logic gates. Quantum gates, such as the Pauli-X, Pauli-Y, Pauli-Z, Hadamard, and CNOT gates, are applied to qubits to perform quantum computations and build quantum circuits.

Quantum interconnects: Components responsible for coupling qubits and transferring quantum information between them, either within a single quantum processor or between multiple processors. These interconnects can be realized through various mechanisms, such as photonic channels, microwave resonators, or direct coupling.

Quantum error correction components: Quantum processors are susceptible to errors due to decoherence, noise, and other factors. Quantum error correction components, such as ancilla qubits and specific error-correcting codes, are incorporated into the active region of quantum processors to detect and correct errors, ensuring reliable computation.

Quantum measurement devices: Quantum computations typically end with a measurement of qubits to extract classical information. Components like single-shot qubit readout circuits or quantum nondemolition measurement devices are part of the active region of quantum processors and play a crucial role in obtaining the final output of a quantum computation.

The exemplary embodiment shown in fig. 3 is related to quantum computing. However, it will be appreciated that the invention can be employed in both quantum and non-quantum applications.

Advantageously, the dielectric layer 6 is absent in at least one first subregion 8, providing a direct connection between the gate electrode layer 4 and the semiconductor substrate 2. This direct connection facilitates electrostatic discharge (ESD) protection at room temperature, while the device operates effectively under cryogenic conditions. The dielectric layer 6 is partially and/or selectively provided in at least one second subregion 8, enveloping active regions of the gate electrode layer. The cryogenic device is designed to operate under thermal conditions that result in a freeze-out phenomenon for the semiconductor substrate, allowing for improved ESD protection during fabrication and packaging. This advantageous approach simplifies the fabrication process and enhances device performance, offering advantages for semiconductor devices for cryogenic applications such as quantum computing or any other applications.

The larger the area of the electrode exposed to the substrate, the better the protection against ESD, as this results in lower resistance between the gate metals at room or elevated temperatures, specifically temperatures above those used during cryogenic operation.

Freeze-out in a semiconductor device refers to a phenomenon that occurs at low temperatures, where the majority of charge carriers, such as electrons and holes, become trapped or "frozen" in their respective energy states, typically at impurity or dopant sites. As a result, the concentration of free charge carriers decreases significantly, leading to reduced electrical conductivity.

At low temperatures, the thermal energy available is not sufficient to excite the trapped charge carriers from their localized energy states back into the conduction or valence bands. This causes the device's electrical characteristics, such as the conductivity, carrier mobility, and threshold voltage, to change as a function of temperature.

The freeze-out phenomenon is particularly important in the study and design of semiconductor devices that operate at cryogenic temperatures or have applications in extreme environments, such as space electronics.

The temperature at which freeze-out typically occurs in a semiconductor device depends on the specific material, doping concentration, and impurity levels. Generally, freeze-out occurs at low temperatures, often in the cryogenic range, which is below about 120 K (-153°C).

For silicon, a widely used semiconductor material, the freeze-out temperature typically falls between 20 K (-253°C) and 100 K (-173°C). However, this range can vary depending on factors such as doping concentration, impurity types, and device fabrication methods.

For other semiconductor materials, like III-V compounds (e.g., GaAs or InP) or II-VI compounds (e.g., CdTe or ZnSe), the freeze-out temperature can also vary depending on the material properties, doping levels, and fabrication techniques.

It will be appreciated that the freeze-out temperature may not be a sharply defined value but rather a transition region where the concentration of free charge carriers starts to decrease significantly as the temperature is lowered.

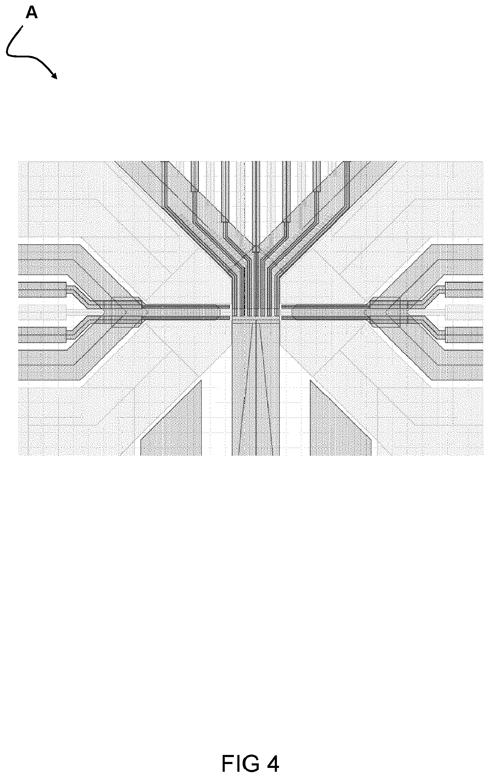

Fig. 4 shows a schematic diagram of an embodiment of an active region A of a cryogenic semiconductor processing/computing device 1. Since the device 1 is designed to operate under cryogenic conditions, and in certain regions, no insulation/dielectric layer is provided, conductive paths are obtained at room temperature, which become non-conductive at low temperatures (cf. freeze-out), allowing the device to function as intended under cryogenic conditions. Cryogenic operation may also refer to devices operating at temperatures at which freeze-out occurs for e.g. intrinsic or compensated doped substrates. The substrate, according to the invention, is designed to freeze out at cryogenic operating temperatures.

For example, in a semiconductor computing device 1, including quantum processors with quantum dots, the active region refers to the portion where the primary quantum and classical electronic activities occur. This region is responsible for the device's intended functionality, enabling both quantum and classical information processing.

The active region of a semiconductor computing device, such as a quantum processor with quantum dots, is the area where essential quantum and classical components interact and operate to enable the processing, storage, or transmission of quantum and classical information. The active region forms the basis for the device's core functionality in both quantum and classical domains.

In a semiconductor computing device, including quantum processors featuring quantum dots, the active region encompasses the zones where the primary quantum and classical electronic processes take place, enabling the execution of intended quantum and classical functions. It consists of various semiconductor elements, such as quantum dots and classical transistors, that work together to carry out these processes and ensure efficient operation.

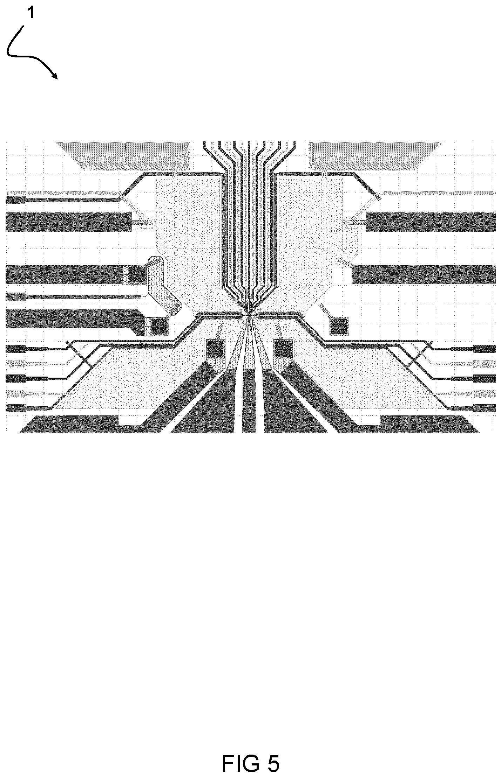

Fig. 5 shows a schematic diagram of a top view of an embodiment of a quantum semiconductor processing device 1. Only part of the device is shown, zoomed in on the active region of the device. According to the invention, the quantum semiconductor processing device 1 may be manufactured with a selective and/or partial arrangement of a dielectric layer between the gate electrode layer and the semiconductor substrate. The dielectric layer's strategic placement provides a direct connection between the gate electrode layer and the semiconductor substrate in certain subregions 8. The active region of the device may not be encompassed in the subregion 8.

A distinction may be made between an active region and a non-active region. In the active region, the dielectric layer is necessary for the device's functionality at low temperatures, while in the non-active region, the dielectric layer is not required. The absence of the dielectric layer in the non-active region forms conductive paths between the gate electrodes and the substrate at room temperature. However, when the device is cooled to cryogenic operating temperatures, the substrate freezes out, effectively eliminating these conductive paths and allowing the device to function as intended.

The advantageous technical effect stems from the device's ability to prevent electrostatic discharge at room temperature by short-circuiting the gate metals through the substrate. This is achieved by placing the gate electrodes directly on the substrate in the non-active region. Once the device is cooled to cryogenic temperatures, the substrate freezes out, causing it to become non-conductive and allowing the device to operate as intended under cryogenic conditions.

The invention thus provides for an advantageous placement and selective arrangement of the dielectric layer in a cryogenic semiconductor processing device 1. This design choice enables effective prevention of electrostatic discharge at room temperature and ensures the device's proper functionality under cryogenic conditions. By leveraging the selective insulation provided by the dielectric layer and the freeze-out properties of the substrate material, this invention offers an innovative and advantageous solution for cryogenic semiconductor applications.

In some examples, the subregion encompassing the active region may be a square that includes all parts of the active region with an optional margin, or it can be a more complex shape that is not necessarily square. Such predetermined shapes may make the manufacturing process easier. It is envisaged that the subregion has other shapes or sizes. In some examples, the dielectric layer is provided selectively at locations where the gate metal layers overlap, and under the accumulation gates, where electrons accumulate within the underlying structure to facilitate the device's functionality. Also in this case, some margin may be provided. It will be appreciated that in this way the area of the subregion 8 can be increased, which can improve the protection against ESD.

It will be appreciated that the term "freeze-out temperature" as used herein refers to a temperature range, typically in the cryogenic regime, at which a majority of charge carriers within a semiconductor device, such as electrons and holes, become trapped or localized at impurity or dopant sites, resulting in a significant reduction in the concentration of free charge carriers and a consequent decrease in the electrical conductivity of the semiconductor material, with the specific temperature range being dependent on factors including but not limited to the semiconductor material, doping concentration, and impurity levels.

In some examples, the cryogenic semiconductor computing device is an apparatus or system comprising semiconductor materials and components, such as transistors, diodes, qubits, or quantum dots, that directly participate in and contribute to the processing, storage, or transmission of electronic or quantum information, including but not limited to devices functioning as electronic processors, integrated circuits, memory devices, or quantum processors, and configured to operate at cryogenic temperatures, for example below approximately 120 K (-153°C), ensuring reliable performance and proper functionality under such low-temperature conditions.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to `only one', but instead are used to mean 'at least one', and do not exclude a plurality. The term "and/or" includes any and all combinations of one or more of the associated listed items. The mere fact that certain measures are recited in mutually different claims does not indicate that a combination of these measures cannot be used to an advantage.

## Claims

1. A cryogenic semiconductor processing device configured to operate under cryogenic conditions, the cryogenic semiconductor device comprising a semiconductor substrate, at least one gate electrode layer, and a dielectric layer partially arranged between the gate electrode layer and the semiconductor substrate, wherein the dielectric layer is absent in at least one first subregion between the gate electrode layer and the semiconductor substrate providing a direct connection therebetween.

2. The cryogenic semiconductor processing device according to claim 1, wherein the at least one first subregion does not encompass one or more active regions of the gate electrode layer.

3. The cryogenic semiconductor processing device according to claim 1 or 2, wherein the dielectric layer is only provided in at least one second subregion between the gate electrode layer and the semiconductor substrate, wherein the at least one second subregion envelops one or more active regions of the gate electrode layer.

4. The cryogenic semiconductor processing device according to claim 3, wherein the at least one second subregion delineates the one or more active regions of the gate electrode layer.

5. The cryogenic semiconductor processing device according to any one of the preceding claims, wherein between 10% to 90% of a total area between the gate electrode layer and the semiconductor substrate is substantially unoccupied by the dielectric layer.

6. The cryogenic semiconductor processing device according to any one of the preceding claims 3-5, wherein the at least one second subregion covers portions of the gate electrode layer in which multiple gate metals are arranged on top of each other with at least partial overlap therebetween.

7. The cryogenic semiconductor processing device according to any one of the preceding claims 3-6, wherein the at least one second subregion covers portions of the gate electrode layer including accumulation gates.

8. The cryogenic semiconductor processing device according to any one of the preceding claims 3-7, wherein the at least one second subregion covers areas where during operation charge carriers are created in the semiconductor for providing the functionality of the device.

9. The cryogenic semiconductor processing device according to any one of the preceding claims, wherein the cryogenic device is configured to operate under thermal conditions that result in a freeze-out phenomenon for the semiconductor substrate.

10. The cryogenic semiconductor processing device according to any one of the preceding claims, wherein the semiconductor substrate is an intrinsic or compensation-doped substrate.

11. A method of manufacturing a semiconductor processing device, the method including providing a semiconductor substrate, at least one gate electrode layer and a dielectric layer arranged between the gate electrode layer and the semiconductor substrate, wherein the dielectric layer is omitted in at least one first subregion between the gate electrode layer and the semiconductor substrate providing a direct connection therebetween.

12. The method according to claim 11, wherein the method includes:
depositing a dielectric material onto the semiconductor substrate, wherein the dielectric material is configured to substantially cover the semiconductor substrate, selectively remove the dielectric material from the semiconductor substrate while maintaining the dielectric material over one or more active regions of the gate electrode layer, resulting in a partially removed dielectric layer so that is only present enveloping the one or more active regions of the gate electrode layer.

13. The method according to claim 11, wherein the method includes:
selectively depositing a dielectric material onto the semiconductor substrate through a patterned deposition process, wherein the dielectric material is configured to be selectively applied over one or more active regions of the gate electrode layer.

14. An electronic device comprising a cryogenic semiconductor processing device according to any one of the preceding claims 1-10.

15. A quantum computing unit comprising a cryogenic semiconductor processing device according to any one of the preceding claims 1-10.
